# EUROPEAN PATENT APPLICATION

(11) **EP 4 507 466 A1**
(43) Date of publication of application: **12.02.2025**
(21) Application number: 23306347.8
(22) Date of filing: 07.08.2023
(51) Int. Cl.: H05K 7/20

(54) **INTELLIGENT TEMPERATURE CONTROL AND BALANCE OF DATACENTER LIQUID COOLING ARRANGEMENTS**

(71) Applicant: OVH, 59100 Roubaix (FR)
(72) Inventor: CHEHADE, Ali, 59283 Moncheaux (FR)
(74) Representative: BCF Global

(57) **Abstract**

A liquid cooling method and system for cooling rack-mounted processing assemblies is presented that provides a dry cooling unit, a first liquid distribution circuit to convey the cooling liquid and a second liquid distribution circuit to convey the heated liquid from the rack-mounted processing assemblies, in which each of the rack-mounted data processing assemblies comprises a smart control valve designed to be pressure independent and control the flow rate of the cooling fluid based on detected temperatures and pressure flows. Each of the smart control valves operative to measure current liquid flow rates, current input cooling liquid temperatures, and current output heated liquid temperatures and calculate a current differential temperature, determine a relationship between the current differential temperature and a target temperature value, and dynamically adjust the liquid flow rate of the smart control valve based on the determined relationship and the current liquid flow rate and current input cooling liquid temperature.

## Description

### FIELD

The present technology generally relates to the field of datacenter cooling measures and, in particular, to the control and balance of liquid cooling arrangements for datacenter rack-mounted processing assemblies.

### BACKGROUND

Datacenters as well as many computer processing facilities house multitudes rack-mounted electronic processing equipment. In operation, such electronic processing equipment generates a substantial amount of heat that must be dissipated in order avoid electronic component failures and ensure continued efficient processing operations.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source, e.g., heat exchangers, dry coolers, municipal water supply *etc.*, via a liquid cooling loop arrangement to circulate the cooling liquid throughout the equipment. As such, the liquid cooling blocks are positioned to be in direct thermal contact with the heat-generating components, so that the received cooling liquid absorbs the generated heat and the heated liquid is circulated, via the cooling loop arrangement, back to cooling liquid source for re-cooling.

Another liquid cooling measure employs liquid immersive cooling (IC) techniques, in which the electronic processing equipment is disposed within an immersion case containing cooling dielectric fluid. In this manner, the submerged electronic processing equipment radiates heat that is absorbed by the cooling dielectric fluid in which the heated dielectric fluid is circulated, via a cooling loop arrangement, back to cooling source for re-cooling.

Relatedly, hybrid liquid cooling measures have been introduced that employ a combination of both liquid block cooling techniques and liquid IC techniques as well as various cooling loop arrangements in efforts to maximize the cooling of electronic processing equipment.

With this said, there remains an interest in improving the control and balance of cooling liquid temperatures received by the electronic processing equipment and heated liquid temperatures returned back to cooling sources to optimize cooling efficiency.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on certain drawbacks associated with conventional dry cooling techniques and implementations.

In one aspect, the inventive concepts of the present technology provides a method for controlling and balancing a liquid cooling arrangement for datacenter rack-mounted processing assemblies comprising providing a dry cooling unit to supply a cooling liquid to the rack-mounted processing assemblies and receive a heated liquid from the rack-mounted processing assemblies; providing a first liquid distribution circuit to convey the cooling liquid from the dry cooling unit to the rack-mounted processing assemblies and a second liquid distribution circuit to convey the heated liquid from the rack-mounted processing assemblies to the dry cooling unit in which each of the rack-mounted data processing assemblies comprises: at least one heat-generating electronic processing element and at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and a smart control valve respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and pressure flows.

The method also comprises that each smart control valve operates to execute an initialization process including measuring the liquid flow rate, input cooling liquid temperature, and output heated liquid temperature of the corresponding rack-mounted data processing assembly, and calculating a differential temperature between the input cooling liquid temperature and output heated liquid temperature, determining a relationship between the differential temperature and a target temperature value, and initializing the liquid flow rate of the smart control valve based on the determined relationship prior to operations.

The method also comprises that each smart control valve operates to execute an operational process comprising measuring a current liquid flow rate, current input cooling liquid temperature, and current output heated liquid temperature of the corresponding rack-mounted data processing assembly, and calculating a current differential temperature between the current input cooling liquid temperature and current output heated liquid temperature, determining a relationship between the current differential temperature and a target temperature value, and dynamically adjusting the liquid flow rate of the smart control valve based on the determined relationship and the current liquid flow rate and current input cooling liquid temperature.

The method further comprises that for the initialization process, when the differential temperature is less than the target temperature value, decrementing the liquid flow rate of the corresponding smart control valve after confirming that the decremented flow rate is not below a minimum flow rate limit, when the differential temperature is equal to the target temperature value, determining whether at the input cooling liquid temperature, internal temperatures of the rack-mounted processing assembly are less than a predetermined lower temperature limit, when the internal temperatures are less than the predetermined lower temperature limit, decrementing the liquid flow rate of the corresponding smart control valve, and when the internal temperatures are greater than the predetermined lower temperature limit, incrementing the liquid flow rate of the corresponding smart control valve.

The method further comprises that for the operational process, when the current differential temperature is greater than the target temperature value, incrementing the liquid flow rate of the corresponding smart control valve, when the incremented liquid flow rate is the same as the current flow rate, issuing an alert message indicating that the liquid flow rate of the corresponding smart control valve is insufficient, when the current differential temperature is less than the target temperature value, decrementing the liquid flow rate of the corresponding smart control valve after confirming that the decremented flow rate is not below a minimum flow rate limit.

The method additionally comprises that for the operational process, when the current differential temperature is equal to the target temperature value, determining whether at the current input cooling liquid temperature, internal temperatures of the rack-mounted processing assembly are less than a predetermined lower temperature limit, when the internal temperatures are less than the predetermined lower temperature limit, decrementing the liquid flow rate of the corresponding smart control valve, and then checking whether the decremented flow rate is below a minimum flow rate limit or the current differential temperature is greater than the target temperature plus an offset temperature.

The method also comprises that for the operational process, when the decremented flow rate is below a minimum flow rate limit or the current differential temperature is greater than the target temperature plus an offset temperature, incrementing the current liquid flow rate of the corresponding smart control valve, when the internal temperatures of the rack-mounted processing assembly are greater than a predetermined lower temperature limit, issuing a message indicating a precautionary message indicating a potential trend of high temperatures and incrementing the incrementing the current liquid flow rate of the corresponding smart control valve.

In a related aspect of the inventive concepts, the present technology provides a controlled and balanced liquid cooling arrangement for datacenter rack-mounted processing assemblies, comprising a dry cooling unit configured to supply a cooling liquid to the rack-mounted processing assemblies and receive a heated liquid from the rack-mounted processing assemblies; a first liquid distribution circuit configured to convey the cooling liquid from the dry cooling unit to the rack-mounted processing assemblies, the first liquid distribution circuit incorporating a pump configured to drive a flow of the cooling liquid supplied by the dry cooling unit; a second liquid distribution circuit configured to convey the heated liquid from the rack-mounted processing assemblies to the dry cooling unit; in which each of the rack-mounted data processing assemblies comprises: at least one heat-generating electronic processing element, at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and a smart control valve respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and pressure flows.

The liquid cooling arrangement also comprises that each smart control valve operates in an initialization mode to measure the liquid flow rate, input cooling liquid temperature, and output heated liquid temperature of the corresponding rack-mounted data processing assembly, calculate a differential temperature between the input cooling liquid temperature and output heated liquid temperature, determine a relationship between the differential temperature and a target temperature value, and initialize the liquid flow rate of the smart control valve based on the determined relationship prior to an operational mode.

The liquid cooling arrangement further comprises that each smart control valve operates in an operational mode in which when the current differential temperature is greater than the target temperature value, incrementing the liquid flow rate of the corresponding smart control valve and if the incremented liquid flow rate is the same as the current flow rate, issuing an alert message indicating that the liquid flow rate of the corresponding smart control valve is insufficient; when the current differential temperature is equal to the target temperature value, determining whether at the current input cooling liquid temperature, internal temperatures of the rack-mounted processing assembly are less than a predetermined lower temperature limit; and when the internal temperatures are less than the predetermined lower temperature limit, decrementing the liquid flow rate of the corresponding smart control valve, and then checking whether the decremented flow rate is below a minimum flow rate limit or the current differential temperature is greater than the target temperature plus an offset temperature.

The liquid cooling arrangement additionally comprises that when in operational mode, for the current input cooling liquid temperature, when the internal temperatures of the rack-mounted processing assembly are greater than a predetermined lower temperature limit, issuing a message indicating a precautionary message indicating a potential trend of high temperatures and incrementing the incrementing the current liquid flow rate of the corresponding smart control valve.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 illustrates a high-level functional block diagram of a controlled and balanced liquid cooling arrangement for datacenter rack-mounted processing assemblies, in accordance with the nonlimiting embodiments of the present technology;
FIG. 2A illustrates a flow diagram of a initialization process for controlling and balancing a liquid cooling system for rack-mounted processing assemblies, in accordance with the nonlimiting embodiments of the present technology; and
FIG. 2B illustrates a flow diagram of an operational continuous process for controlling and balancing a liquid cooling system for rack-mounted processing assemblies, in accordance with the nonlimiting embodiments of the present technology.

It should be appreciated that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Given this fundamental understanding, the disclosed embodiments are directed to the control and balance of a datacenter liquid cooling system for rack-mounted processing assemblies. The control and balance of the liquid cooling system is based on maintaining an optimal differential temperature between supplied cooling liquid and returned heated liquid by dynamically adjusting the liquid flow rate for each individual rack-mounted processing assembly.

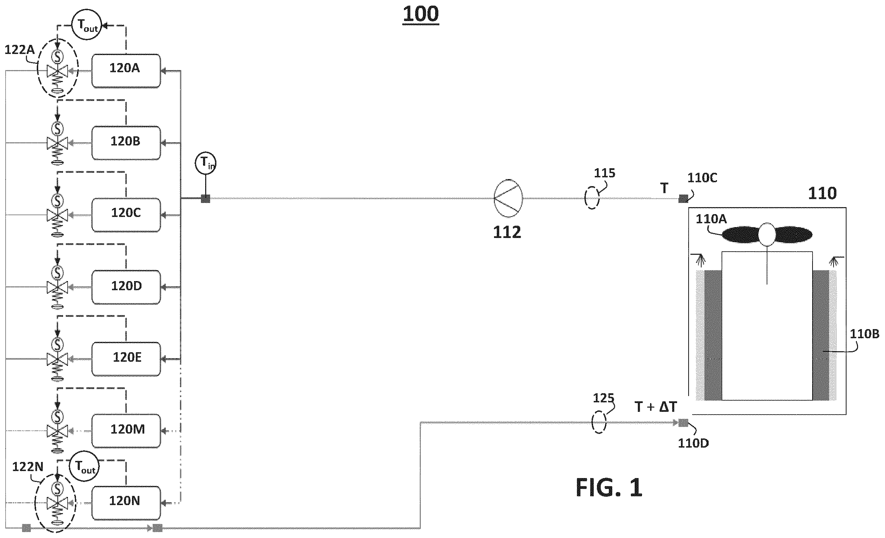

FIG. 1 illustrates the general architecture of a controlled and balanced liquid cooling system **100** for rack-mounted processing assemblies, in accordance with the non-limiting embodiments of the present technology. As shown, the system **100** includes a dry cooling unit **110**, a plurality of rack-mounted processing assemblies **120A-120N**, a plurality of "smart" valves **122A-122N** in which each smart valve is fluidly-coupled to a respective processing assembly, a forward liquid distribution circuit **115** incorporating a pump **112** for supplying cooling liquid from the dry cooling unit **110**, and a return liquid distribution circuit **125** for returning heated liquid back to the dry cooling unit **110.**

The dry cooling unit **110** incorporates an outlet **110C** configured to supply cooling liquid and an inlet **110D** configured receive heated liquid. The dry cooling unit **110** serves to dissipate thermal energy from a heated liquid circulating therethrough to the ambient environment. For example, in a datacenter or similar facility, the dry cooling unit **110** operates to receive heated liquid from the rack-mounted processing assemblies **120A-120N** (e.g., water circulated through water blocks in contact with heat-generating components) and extracts the thermal energy from the heated liquid by dissipating the energy into the ambient environment via the at least one fan assembly **110A**, thereby re-cooling the heated liquid. The dry cooling unit **110** then operates to supply the re-cooled liquid back to the rack-mounted processing assemblies **120A-120N.**

As shown, the dry cooling unit **110** includes at least one heat exchanger **110B** and at least one fan assembly **110A.** The heat exchanger **110** may manifest a variety of configurations, such as, air-to-liquid heat exchanger etc., and may further include evaporating or cooling pads. For purposes of the instant disclosure, the exact configuration of the dry cooling unit **110** and heat exchanger **110** is not limiting, as various configurations could be employed without departing from the concepts of the instant disclosure.

The cooling/re-cooled liquid is supplied by the dry cooling unit **110** to the rack-mounted processing assemblies **120A-120N** via the outlet **110C** and forward liquid distribution circuit **115.** The forward liquid distribution circuit **115** incorporates a pump **112** to maintain the flow rate of the cooling/re-cooled liquid supplied to the processing assemblies **120A-120N** at an adequate level.

The heated liquid from the rack-mounted processing assemblies **120A-120N** is returned back to the dry cooling unit **110** for re-cooling via the inlet **110D** and return liquid distribution circuit **125.** As shown, the dry cooling unit **110** supplies the cooling/re-cooled liquid to the rack-mounted processing assemblies **120A-120N** at a nominal temperature T and the heated liquid returned to the dry cooling unit **110** is at a nominal temperature T + ΔT, where ΔT represents the temperature differential between the cooling/re-cooled liquid and the heated liquid.

Returning to FIG. 1, the liquid cooling system **100** includes a plurality of rack-mounted processing assemblies **120A-120N** which receive the supplied cooling/re-cooled liquid via the forward liquid distribution circuit **115**, internally channel the liquid to the heat-generating processing components (e.g., water circulated through water blocks), and convey the heated liquid from the heat-generating processing components to the return liquid distribution circuit **125.**

The rack-mounted processing assemblies **120A-120N** may or may not be configured with similar heat-generating processing components. As such, each of the rack-mounted processing assemblies **120A-120N** may have different temperature and flow rate requirements for proper operations.

It will be appreciated that, while the rack-mounted processing assemblies **120A-120N** are shown to be arranged in a parallel configuration, it is not meant to be limiting, as the processing assemblies **120A-120N** may also be arranged in a serial or combined parallel and serial configuration without departing from the concepts of the instant disclosure.

As shown, each of the rack-mounted processing assemblies **120A-120N** is fluidly-coupled to a "smart" valve **122A-122N** that dynamically controls the flow rate of the corresponding processing assembly **120A-120N** based on detected liquid temperatures. For purposes of the instant disclosure, the term "smart" valve refers to a valve that is pressure-independent, temperature-responsive, and incorporates a differential pressure regulator to automatically adjust to system pressure changes. Such smart valves may comprise PICVs, ABQMs, or other functionally similar valves or combinations of valves, such as a solenoid valve combined with a control valve.

As shown, the temperature of the liquid ingressing into each of the rack-mounted processing assemblies **120A-120N** is measured as Tᵢₙ which, depending on environmental factors and distances traversed, may or may not be the same as the temperature T of the cooling/re-cooled liquid supplied by the dry cooling unit **110.**

The heated liquid egressing out of each of the rack-mounted processing assemblies **120A-120N** is provided to the corresponding smart valve **122A-122N.** Additionally, the temperature of the heated liquid egressing out of each processing assembly **120A-120N** is measured as Tₒᵤₜ, which is also provided to the corresponding smart valve **122A-122N.**

As will be described in detail below, based on the measured Tᵢₙ and Tₒᵤₜ of each of the processing assemblies **120A-120N**, the corresponding smart valve **122A-122N** functions to dynamically control the individual liquid flow rate of each of the rack-mounted processing assemblies to balance and maintain an optimal temperature differential ΔT between the supplied cooling/re-cooled liquid and the returned heated liquid of system **100.** Maintaining this optimal temperature differential ΔT results in improved cooling system efficiency.

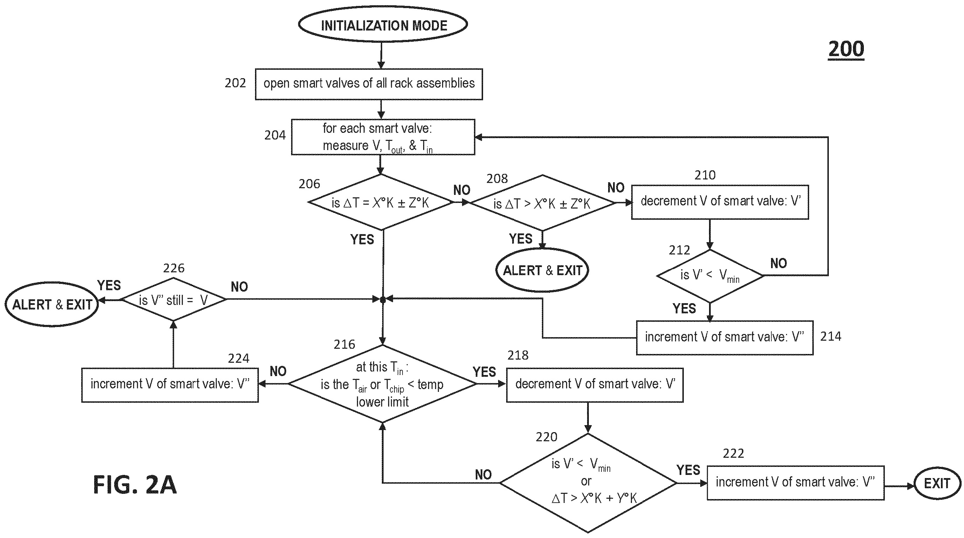

With this said, FIG. 2A illustrates a flow diagram of initialization process **200** for controlling and balancing a liquid cooling system for rack-mounted processing assemblies, in accordance with the non-limiting embodiments of the present technology. In some embodiments, initialization process **200** or portions thereof are to be executed by the individual rack-mounted processing assemblies that are respectively and directly connected to the smart valves **122A-122N.** In other embodiments, initialization process **200** or portions thereof may be executed by a master control unit that is communicatively coupled to each of the individual rack-mounted processing assemblies. For purposes of the instant disclosure, the exact entity or entities executing initialization process is not limiting with regard to the concepts provided by the instant disclosure.

As such, initialization process **200** commences at task block **202**, in which each of the of smart valves **122A-122N** for all of the rack-mounted processing assemblies **120A-120N** are opened. At task block **204**, for each individual rack-mounted processing assembly **120A-120N**, process **200** measures the liquid flow rate V of the rack-mounted assembly, the temperature of the heated liquid egressing out of the rack-mounted assembly Tₒᵤₜ, and the temperature of the cooling liquid ingressing into the rack-mounted assembly **120A-120N** Tᵢₙ.

At decision block **206**, process **200** determines whether the temperature differential ΔT between the ingressing cooling liquid and the egressing heated liquid is equal to a target temperature *X* °K within a tolerance value ± *Z*°K. If not, at decision block **208**, it is determined whether the temperature differential ΔT is greater than the tolerated target temperature *X* °K ± *Z*°K and if it is, process **200** determines that the liquid flow rate V is insufficient and issues an alert message and exits the process. The tolerated target temperature *X* °K ± *Z* °K is directly related to the optimal temperature differential ΔT that results in the improved cooling system efficiency.

However, if at decision block **208**, it is determined that the temperature differential ΔT is not greater than the target temperature *X* °K ± *Z* °K, then the liquid flow rate V is decremented by a predetermined value to V' at task block **210.** The predetermined decremental and incremental values may be based on a percentage of the total flow amount or on a quantified liter/min per kW amount. In turn, at decision block **212**, it is determined whether the decremented liquid flow rate V' is less than a predetermined minimum liquid flow rate Vₘᵢₙ and, if it is not, process **200** reverts back to task block **204** for the re-measuring of the liquid flow rate V', the temperature of the heated liquid Tₒᵤₜ, and the temperature of the cooling liquid Tᵢₙ. If at decision block **212**, it is determined that the decremented liquid flow rate V' is less than the minimum liquid flow rate Vₘᵢₙ, the liquid flow rate V' is then incremented by a predetermined value to V" and directed to decision block **216** to be explained below.

Turning back to decision block **206**, if it is determined that the temperature differential ΔT is equal to the tolerated target temperature *X*°K ± *Z* °K, process **200** progresses to decision block **216** to determine whether, for the temperature of the cooling liquid Tᵢₙ, certain internal temperature metrics of the rack-mounted processing assemblies **120A-120N**, such as, for example, air flow temperatures Tₐᵢᵣ and processing component temperatures T_{chips}, are less than a predetermined lower temperature limit, and if so, the liquid flow rate V is decremented by a predetermined value to V' at task block **218.**

Process **200** then progresses to decision block **220** to determine whether decremented liquid flow rate V' is less than the predetermined minimum liquid flow rate Vₘᵢₙ or whether the temperature differential ΔT is greater than the tolerated target *X* °K ± *Z* °K in addition to an acceptable offset temperature *Y* °K. If any one of these conditions are met, process **200** moves to task block **222** to increment the liquid flow rate V by a predetermined value to V" and then exit process **200.**

If none of the conditions of decision block **220** are met, process **200** returns back to decision block **216** which again determines if for the temperature Tᵢₙ, certain internal temperature metrics of the rack-mounted processing assemblies **120A-120N**, such as, Tₐᵢᵣ and T_{chips} are less than a predetermined lower temperature limit, and if so, process **200** cycles back through blocks **218**, **220**, and **222.** However, if none of the conditions of decision block **216** are met, process **200** advances to block **224** to increment the liquid flow rate V by a predetermined value to V" and moves to decision block **226.**

At decision block **226**, it is determined whether the incremented flow rate V" is the same as liquid flow rate V, and if so, process **200** determines that the liquid flow rate V" is insufficient and issues an alert message and exits the process. However, if incremented flow rate V" is not the same as liquid flow rate V, process **200** cycles back to decision block **216.**

In this manner, process **200** initializes system **100** to calibrate each of the smart valves **122A-122N** corresponding to each of the rack-mounted processing assemblies **120A-120N** in order to balance liquid flow rates and temperatures to maintain an optimal temperature differential ΔT between the supplied cooling/re-cooled liquid and the returned heated liquid for maximum cooling efficiency.

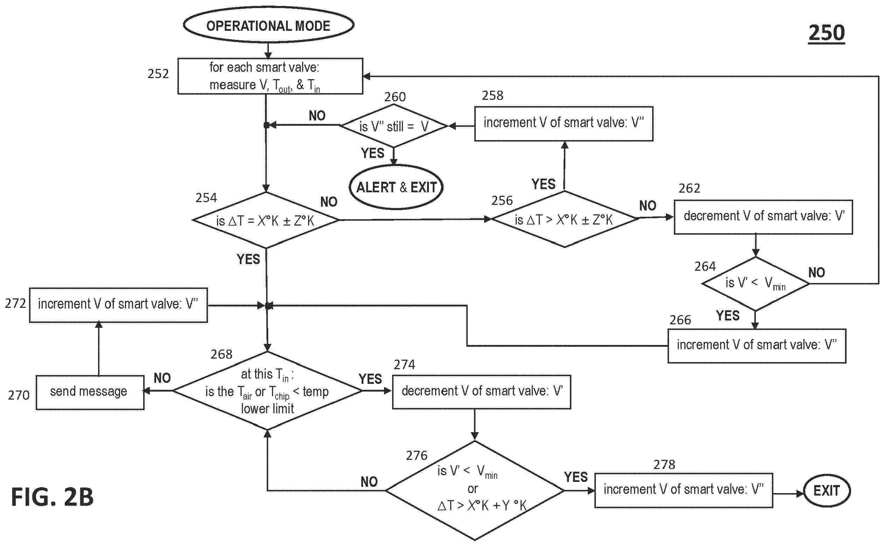

FIG. 2B illustrates a flow diagram of operational process **250** for controlling and balancing a liquid cooling system for rack-mounted processing assemblies, in accordance with the nonlimiting embodiments of the present technology. In some embodiments, operational process **250** or portions thereof are to be executed by the individual rack-mounted processing assemblies that are respectively and directly connected to the smart valves **122A-122N.** In other embodiments, operational process **250** or portions thereof may be executed by a master control unit that is communicatively coupled to each of the individual rack-mounted processing assemblies. For purposes of the instant disclosure, the exact entity or entities executing initialization process is not limiting with regard to the concepts provided by the instant disclosure.

Operational process **250** commences at task block **252**, in which for each individual rack-mounted processing assembly **120A-120N**, the liquid flow rate V of the rack-mounted assembly, the temperature of the heated liquid egressing out of the rack-mounted assembly Tₒᵤₜ, and the temperature of the cooling liquid ingressing into the rack-mounted assembly **120A-120N** Tᵢₙ are measured.

Process **250** then moves to decision block **254**, where it is determined whether the temperature differential ΔT between the ingressing cooling liquid and the egressing heated liquid is equal to a target temperature *X* °K within a tolerance value ± *Z*°K. If not, decision block **256** determines whether the temperature differential ΔT is greater than the tolerated target temperature *X* °K ± Z°K and if it is, the liquid flow rate V is incremented by a predetermined value to V". Then, decision block **260** determines whether incremented flow rate V" is the same as liquid flow rate V, and if so, process **250** determines that the liquid flow rate V" is insufficient and issues an alert message and exits the process. However, if V" is not the same as liquid flow rate V, process **250** returns back to decision block **254.**

Returning back to decision block **256**, if it is determined that the temperature differential ΔT is not greater than the tolerated target temperature *X* °K ± Z°K, process **250** decrements the liquid flow rate V by a predetermined value to V' at task block **262** and then, at decision block **264**, determines whether the decremented liquid flow rate V' is less than a predetermined minimum liquid flow rate Vₘᵢₙ. The predetermined minimum liquid flow rate Vₘᵢₙ is configured to prevent laminar flows within the internally channelized liquid circulated within water blocks, limit the accumulated deposition of debris or minerals within the water blocks, and/or prevent overheating within the channels.

If decision block **264** determines that V' is not less than Vₘᵢₙ, process **250** returns back to task block **252** for the remeasuring of V, Tᵢₙ, and Tₒᵤₜ of the rack-mounted assembly. If decision block **264** determines that V' is less than Vₘᵢₙ, process **250** advances to task block **266** to increment the liquid flow rate V by the predetermined value to V".

Returning back to decision block **254**, if it is determined that the temperature differential ΔT is equal to a target temperature *X* °K within a tolerance value ± Z°K, process **250** advances to decision block **268** to determine whether, for the temperature of the cooling liquid Tᵢₙ, certain internal temperature metrics of the rack-mounted processing assemblies **120A-120N**, such as, for example, air flow temperatures Tₐᵢᵣ and processing component temperatures T_{chips}, are less than a predetermined lower temperature limit. If the Tₐᵢᵣ and T_{chips} temperatures are not, at task **270**, process **250** issues a precautionary message indicating the potential of high temperatures within the rack-mounted processing assemblies **120A-120N.** Then, at task block **272**, the liquid flow rate V is incremented by the predetermined value to V".

On the other hand, if decision block **268** determines that the air flow temperatures Tₐᵢᵣ and processing component temperatures T_{chips} are less than the predetermined lower temperature limit, process **250** advances to task block **274** to decrement the liquid flow rate V by a predetermined value to V'. Then, decision block **276** determines whether the decremented liquid flow rate V' is less than the predetermined minimum liquid flow rate Vₘᵢₙ or whether the temperature differential ΔT is greater than the tolerated target temperature tolerated target temperature *X* °K ± Z°K in addition to an acceptable offset temperature *Y* °K*.* If none of these conditions are met, process **250** cycles back to decision block **268.** However, if any of these conditions are met, process **250** moves to task **278** to increment the liquid flow rate V by the predetermined value to V" and then exits the process.

In this manner, process **250** functions to control and balance the liquid flow rates of provided by each of the smart valves **122A-122N** corresponding to each of the rack-mounted processing assemblies **120A-120N** during operations, in order to maintain an optimal temperature differential ΔT between the supplied cooling/re-cooled liquid and the returned heated liquid for maximum cooling efficiency.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling method (200, 250) for rack-mounted processing assemblies (120A-120N), comprising:
providing a dry cooling unit (110) to supply a cooling liquid to the rack-mounted processing assemblies and receive a heated liquid from the rack-mounted processing assemblies;
providing a first liquid distribution circuit (115) to convey the cooling liquid from the dry cooling unit to the rack-mounted processing assemblies and a second liquid distribution circuit (125) to convey the heated liquid from the rack-mounted processing assemblies to the dry cooling unit;
wherein, each of the rack-mounted data processing assemblies (120A-120N) comprises:
at least one heat-generating electronic processing element and at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and
a smart control valve (122A-122N) respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and pressure flows;
wherein, each smart control valve operates to execute an initialization process (200), comprising:
measuring the liquid flow rate, input cooling liquid temperature, and output heated liquid temperature of the corresponding rack-mounted data processing assembly, and calculating a differential temperature between the input cooling liquid temperature and output heated liquid temperature (204),
determining a relationship between the differential temperature and a target temperature value (206), and
initializing the liquid flow rate of the smart control valve based on the determined relationship prior to operations (210, 214, 218, 222, 224); and
wherein, each smart control valve operates to execute an operational process (250), comprising:
measuring a current liquid flow rate, current input cooling liquid temperature, and current output heated liquid temperature of the corresponding rack-mounted data processing assembly, and calculating a current differential temperature between the current input cooling liquid temperature and current output heated liquid temperature (252),
determining a relationship between the current differential temperature and a target temperature value (254, 256), and
dynamically adjusting the liquid flow rate of the smart control valve based on the determined relationship and the current liquid flow rate and current input cooling liquid temperature (258, 262, 266, 272, 274, 278).

2. The liquid cooling method of claim 1, wherein the initialization process (200) further comprises that, when the differential temperature is greater than the target temperature value, issuing an alert message indicating that the liquid flow rate of the corresponding smart control valve is insufficient.

3. The liquid cooling method of claims 1 or 2, wherein the initialization process (200) further comprises that, when the differential temperature is less than the target temperature value, decrementing the liquid flow rate of the corresponding smart control valve after confirming that the decremented flow rate is not below a minimum flow rate limit (210, 212).

4. The liquid cooling method of any one of claims 1 to 3, wherein the initialization process (200) further comprises that, when the differential temperature is equal to the target temperature value (206), determining whether at the input cooling liquid temperature, internal temperatures of the rack-mounted processing assembly are less than a predetermined lower temperature limit (216), and
when the internal temperatures are less than the predetermined lower temperature limit, decrementing the liquid flow rate of the corresponding smart control valve (218), and
when the internal temperatures are greater than the predetermined lower temperature limit, incrementing the liquid flow rate of the corresponding smart control valve (224).

5. The liquid cooling method of claim 1, wherein the operational process (250) further comprises that, when the current differential temperature is greater than the target temperature value, incrementing the liquid flow rate of the corresponding smart control valve (258).

6. The liquid cooling method of claim 5, wherein the operational process (250) further comprises that, when the incremented liquid flow rate is the same as the current flow rate, issuing an alert message indicating that the liquid flow rate of the corresponding smart control valve is insufficient (260).

7. The liquid cooling method of claims 5 or 6, wherein the operational process (250) further comprises that, when the current differential temperature is less than the target temperature value, decrementing the liquid flow rate of the corresponding smart control valve after confirming that the decremented flow rate is not below a minimum flow rate limit (262, 264).

8. The liquid cooling method of any one of claims 5 to 7, wherein the operational process (250) further comprises that, when the current differential temperature is equal to the target temperature value, determining whether at the current input cooling liquid temperature, internal temperatures of the rack-mounted processing assembly are less than a predetermined lower temperature limit (268), and
when the internal temperatures are less than the predetermined lower temperature limit, decrementing the liquid flow rate of the corresponding smart control valve (274), and then checking whether the decremented flow rate is below a minimum flow rate limit or the current differential temperature is greater than the target temperature plus an offset temperature (276).

9. The liquid cooling method of claim 8, wherein the operational process (250) further comprises that, when the decremented flow rate is below a minimum flow rate limit or the current differential temperature is greater than the target temperature plus an offset temperature (276), incrementing the current liquid flow rate of the corresponding smart control valve (278).

10. The liquid cooling method of claims 8 or 9, wherein the operational process (250) further comprises that, for the current input cooling liquid temperature, when the internal temperatures of the rack-mounted processing assembly are greater than a predetermined lower temperature limit (268), issuing a message indicating a precautionary message indicating a potential trend of high temperatures and incrementing the incrementing the current liquid flow rate of the corresponding smart control valve (272).

11. A liquid cooling system (100) for rack-mounted processing assemblies (120A-120N), comprising:
a dry cooling unit (110) configured to supply a cooling liquid to the rack-mounted processing assemblies and receive a heated liquid from the rack-mounted processing assemblies;
a first liquid distribution circuit (115) configured to convey the cooling liquid from the dry cooling unit to the rack-mounted processing assemblies, the first liquid distribution circuit (115) incorporating a pump (112) configured to drive a flow of the cooling liquid supplied by the dry cooling unit;
a second liquid distribution circuit (125) configured to convey the heated liquid from the rack-mounted processing assemblies to the dry cooling unit;
wherein, each of the rack-mounted data processing assemblies (120A-120N) comprises:
at least one heat-generating electronic processing element,
at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and
a smart control valve (122A-122N) respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and pressure flows;
wherein, in an initialization mode (200), each smart control valve operates to:
measure the liquid flow rate, input cooling liquid temperature, and output heated liquid temperature of the corresponding rack-mounted data processing assembly, and calculate a differential temperature between the input cooling liquid temperature and output heated liquid temperature (204),
determine a relationship between the differential temperature and a target temperature value (206), and
initialize the liquid flow rate of the smart control valve based on the determined relationship prior to an operational mode (210, 214, 218, 222, 224); and
wherein, in the operational mode (250), each smart control valve operates to:
measure a current liquid flow rate, current input cooling liquid temperature, and current output heated liquid temperature of the corresponding rack-mounted data processing assembly, and calculate a differential temperature between the current input cooling liquid temperature and current output heated liquid temperature (252),
determine a relationship between the differential temperature and a target temperature value (254), and
dynamically adjust the liquid flow rate of the smart control valve based on the determined relationship and the measured current liquid flow rate and current input cooling liquid temperature (258, 262, 266, 272, 274, 278).

12. The liquid cooling system of claim 11, wherein the initialization process (200) further comprises that, when the differential temperature is greater than the target temperature value, issuing an alert message indicating that the liquid flow rate of the corresponding smart control valve is insufficient and when the differential temperature is less than the target temperature value, decrementing the liquid flow rate of the corresponding smart control valve after confirming that the decremented flow rate is not below a minimum flow rate limit (210, 212).

13. The liquid cooling system of claims 11 or 12, wherein the initialization process (200) further comprises that, when the differential temperature is equal to the target temperature value (206), determining whether at the input cooling liquid temperature, internal temperatures of the rack-mounted processing assembly are less than a predetermined lower temperature limit (216), and
when the internal temperatures are less than the predetermined lower temperature limit, decrementing the liquid flow rate of the corresponding smart control valve (218), and
when the internal temperatures are greater than the predetermined lower temperature limit, incrementing the liquid flow rate of the corresponding smart control valve (224).

14. The liquid cooling system of claim 11, wherein the operational process (250) further comprises that:
when the current differential temperature is greater than the target temperature value, incrementing the liquid flow rate of the corresponding smart control valve (258) and if the incremented liquid flow rate is the same as the current flow rate, issuing an alert message indicating that the liquid flow rate of the corresponding smart control valve is insufficient (260);
when the current differential temperature is equal to the target temperature value, determining whether at the current input cooling liquid temperature, internal temperatures of the rack-mounted processing assembly are less than a predetermined lower temperature limit (268); and
when the internal temperatures are less than the predetermined lower temperature limit, decrementing the liquid flow rate of the corresponding smart control valve (274), and then checking whether the decremented flow rate is below a minimum flow rate limit or the current differential temperature is greater than the target temperature plus an offset temperature (276).

15. The liquid cooling system of claim 14, wherein the operational process (250) further comprises that, for the current input cooling liquid temperature, when the internal temperatures of the rack-mounted processing assembly are greater than a predetermined lower temperature limit (268), issuing a message indicating a precautionary message indicating a potential trend of high temperatures and incrementing the incrementing the current liquid flow rate of the corresponding smart control valve (272).

## Amended claims

### Amended claims in accordance with Rule 137(2) EPC.

1. A liquid cooling method (200, 250) for rack-mounted processing assemblies (120A-120N), comprising:
providing a dry cooling unit (110) to supply a cooling liquid to the rack-mounted processing assemblies and receive a heated liquid from the rack-mounted processing assemblies;
providing a first liquid distribution circuit (115) to convey the cooling liquid from the dry cooling unit to the rack-mounted processing assemblies and a second liquid distribution circuit (125) to convey the heated liquid from the rack-mounted processing assemblies to the dry cooling unit;
wherein, each of the rack-mounted data processing assemblies (120A-120N) comprises:
at least one heat-generating electronic processing element and at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and
a smart control valve (122A-122N) respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and pressure flows;
wherein, each smart control valve operates to execute an initialization process (200), comprising:
measuring the liquid flow rate, input cooling liquid temperature, and output heated liquid temperature of the corresponding rack-mounted data processing assembly, and calculating a differential temperature between the input cooling liquid temperature and output heated liquid temperature (204),
determining a temperature relationship indicative of whether the differential temperature is greater than, less than, or equal to a target temperature value (206),
determining a liquid flow rate relationship indicative of whether the measured liquid flow rate is greater than, less than, or equal to a minimum liquid flow rate limit (212), and
initializing the liquid flow rate of the smart control valve to calibrate the smart control valve in response to the determined temperature and liquid flow rate relationships prior to operational processing (210, 214, 218, 222, 224); and
wherein, each smart control valve operates to execute an operational process (250), comprising:
measuring a current liquid flow rate, current input cooling liquid temperature, and current output heated liquid temperature of the corresponding rack-mounted data processing assembly, and calculating a current differential temperature between the current input cooling liquid temperature and current output heated liquid temperature (252),
determining a current temperature relationship indicative of whether the current differential temperature is greater than, less than, or equal to the target temperature value (254, 256),
determining a current liquid flow rate relationship indicative of whether the measured current liquid flow rate is greater than, less than, or equal to the minimum liquid flow rate limit (264), and
dynamically adjusting the liquid flow rate of the smart control valve in response to the determined current temperature and current liquid flow rate relationships (258, 262, 266, 272, 274, 278).

2. (Original) The liquid cooling method of claim 1, wherein the initialization process (200) further comprises that, when the differential temperature is greater than the target temperature value, issuing an alert message indicating that the liquid flow rate of the corresponding smart control valve is insufficient.

3. The liquid cooling method of claims 1 or 2, wherein the initialization process (200) further comprises that, when the differential temperature is less than the target temperature value, decrementing the liquid flow rate of the corresponding smart control valve after confirming that the decremented flow rate is not below the minimum flow rate limit (210, 212).

4. (Original) The liquid cooling method of any one of claims 1 to 3, wherein the initialization process (200) further comprises that, when the differential temperature is equal to the target temperature value (206), determining whether at the input cooling liquid temperature, internal temperatures of the rack-mounted processing assembly are less than a predetermined lower temperature limit (216), and
when the internal temperatures are less than the predetermined lower temperature limit, decrementing the liquid flow rate of the corresponding smart control valve (218), and
when the internal temperatures are greater than the predetermined lower temperature limit, incrementing the liquid flow rate of the corresponding smart control valve (224).

5. (Original) The liquid cooling method of claim 1, wherein the operational process (250) further comprises that, when the current differential temperature is greater than the target temperature value, incrementing the liquid flow rate of the corresponding smart control valve (258).

6. (Original) The liquid cooling method of claim 5, wherein the operational process (250) further comprises that, when the incremented liquid flow rate is the same as the current flow rate, issuing an alert message indicating that the liquid flow rate of the corresponding smart control valve is insufficient (260).

7. The liquid cooling method of claims 5 or 6, wherein the operational process (250) further comprises that, when the current differential temperature is less than the target temperature value, decrementing the liquid flow rate of the corresponding smart control valve after confirming that the decremented flow rate is not below the minimum flow rate limit (262, 264).

8. The liquid cooling method of any one of claims 5 to 7, wherein the operational process (250) further comprises that, when the current differential temperature is equal to the target temperature value, determining whether at the current input cooling liquid temperature, internal temperatures of the rack-mounted processing assembly are less than the predetermined lower temperature limit (268), and
when the internal temperatures are less than the predetermined lower temperature limit, decrementing the liquid flow rate of the corresponding smart control valve (274), and then checking whether the decremented flow rate is below the minimum flow rate limit or the current differential temperature is greater than the target temperature plus an offset temperature (276).

9. The liquid cooling method of claim 8, wherein the operational process (250) further comprises that, when the decremented flow rate is below the minimum flow rate limit or the current differential temperature is greater than the target temperature plus an offset temperature (276), incrementing the current liquid flow rate of the corresponding smart control valve (278).

10. (Original) The liquid cooling method of claims 8 or 9, wherein the operational process (250) further comprises that, for the current input cooling liquid temperature, when the internal temperatures of the rack-mounted processing assembly are greater than a predetermined lower temperature limit (268), issuing a message indicating a precautionary message indicating a potential trend of high temperatures and incrementing the incrementing the current liquid flow rate of the corresponding smart control valve (272).

11. A liquid cooling system (100) for rack-mounted processing assemblies (120A-120N), comprising:
a dry cooling unit (110) configured to supply a cooling liquid to the rack-mounted processing assemblies and receive a heated liquid from the rack-mounted processing assemblies;
a first liquid distribution circuit (115) configured to convey the cooling liquid from the dry cooling unit to the rack-mounted processing assemblies, the first liquid distribution circuit (115) incorporating a pump (112) configured to drive a flow of the cooling liquid supplied by the dry cooling unit;
a second liquid distribution circuit (125) configured to convey the heated liquid from the rack-mounted processing assemblies to the dry cooling unit;
wherein, each of the rack-mounted data processing assemblies (120A-120N) comprises:
at least one heat-generating electronic processing element,
at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and
a smart control valve (122A-122N) respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and pressure flows;
wherein, in an initialization mode (200), each smart control valve operates to:
measure the liquid flow rate, input cooling liquid temperature, and output heated liquid temperature of the corresponding rack-mounted data processing assembly, and calculate a differential temperature between the input cooling liquid temperature and output heated liquid temperature (204),
determine a temperature relationship indicative of whether the differential temperature is greater than, less than, or equal to a target temperature value (206),
determine a liquid flow rate relationship indicative of whether the measured liquid flow rate is greater than, less than, or equal to a minimum liquid flow rate limit (212), and
initialize the liquid flow rate of the smart control valve to calibrate the smart control valve in response to the determined temperature and liquid flow rate relationships prior to operational processing (210, 214, 218, 222, 224); and
wherein, in the operational mode (250), each smart control valve operates to:
measure a current liquid flow rate, current input cooling liquid temperature, and current output heated liquid temperature of the corresponding rack-mounted data processing assembly, and calculate a differential temperature between the current input cooling liquid temperature and current output heated liquid temperature (252),
determine a current temperature relationship indicative of whether the current differential temperature is greater than, less than, or equal to the target temperature value (254, 256),
determine a current liquid flow rate relationship indicative of whether the measured current liquid flow rate is greater than, less than, or equal to the minimum liquid flow rate limit (264), and
dynamically adjust the liquid flow rate of the smart control valve in response to the determined current temperature and current liquid flow rate relationships (258, 262, 266, 272, 274, 278).

12. The liquid cooling system of claim 11, wherein the initialization process (200) further comprises that, when the differential temperature is greater than the target temperature value, issuing an alert message indicating that the liquid flow rate of the corresponding smart control valve is insufficient and when the differential temperature is less than the target temperature value, decrementing the liquid flow rate of the corresponding smart control valve after confirming that the decremented flow rate is not below the minimum flow rate limit (210, 212).

13. (Original) The liquid cooling system of claims 11 or 12, wherein the initialization process (200) further comprises that, when the differential temperature is equal to the target temperature value (206), determining whether at the input cooling liquid temperature, internal temperatures of the rack-mounted processing assembly are less than a predetermined lower temperature limit (216), and
when the internal temperatures are less than the predetermined lower temperature limit, decrementing the liquid flow rate of the corresponding smart control valve (218), and
when the internal temperatures are greater than the predetermined lower temperature limit, incrementing the liquid flow rate of the corresponding smart control valve (224).

14. (Original) The liquid cooling system of claim 11, wherein the operational process (250) further comprises that:
when the current differential temperature is greater than the target temperature value, incrementing the liquid flow rate of the corresponding smart control valve (258) and if the incremented liquid flow rate is the same as the current flow rate, issuing an alert message indicating that the liquid flow rate of the corresponding smart control valve is insufficient (260);
when the current differential temperature is equal to the target temperature value, determining whether at the current input cooling liquid temperature, internal temperatures of the rack-mounted processing assembly are less than a predetermined lower temperature limit (268); and
when the internal temperatures are less than the predetermined lower temperature limit, decrementing the liquid flow rate of the corresponding smart control valve (274), and then checking whether the decremented flow rate is below a minimum flow rate limit or the current differential temperature is greater than the target temperature plus an offset temperature (276).

15. (Original) The liquid cooling system of claim 14, wherein the operational process (250) further comprises that, for the current input cooling liquid temperature, when the internal temperatures of the rack-mounted processing assembly are greater than a predetermined lower temperature limit (268), issuing a message indicating a precautionary message indicating a potential trend of high temperatures and incrementing the incrementing the current liquid flow rate of the corresponding smart control valve (272).
